# EUROPEAN PATENT APPLICATION

(11) **EP 2 202 795 A1**
(43) Date of publication of application: **30.06.2010**
(21) Application number: 08291241.1
(22) Date of filing: 24.12.2008
(51) Int. Cl.: H01L 27/146, H01L 31/18, H01L 21/20

(54) **Method for fabricating a semiconductor substrate and semiconductor substrate**

(71) Applicant: S.O.I. TEC Silicon, 38190 Bernin (FR)
(72) Inventor: Figuet, Christophe, 38920 Crolles (FR); Bouvier, Christophe, 38000 Grenoble (FR); Cailler, Celine, 38610 Gieres (FR); Drouin, Alexis, 38530 La Buissiere (FR); Maurice, Thibaut, 38920 Crolles (FR)
(74) Representative: Grünecker, Kinkeldey, Stockmair & Schwanhäusser Anwaltssozietät

(57) **Abstract**

The invention relates to a method for fabricating a semiconductor substrate comprising the steps of: providing a semiconductor on insulator type substrate, providing a diffusion barrier layer and providing a second semiconductor layer. By providing the diffusion barrier layer, it becomes possible to suppress diffusion from the highly doped first semiconductor layer into the second semiconductor layer. The invention also relates to a corresponding semiconductor substrate and opto-electronic devices comprising such a substrate.

## Description

The invention relates to a method for fabricating a semiconductor substrate comprising the steps of: providing a semiconductor on insulator type substrate with a base, an insulating layer and a first semiconductor layer with a first dopant concentration and providing a second semiconductor layer, in particular of the same material as the first semiconductor layer, with the second dopant concentration different compared to the first dopant concentration. The invention furthermore relates to a corresponding semiconductor substrate.

In opto-electronics, like for example in image sensors used in digital CMOS/CCD video or photographic cameras, special substrates, like SOI substrates, are needed. The image sensors formed in the device layer of a SOI substrate are transferred to a final substrate to expose the backside of the sensors to the light entering side of the sensor. It has been proposed to use SOI type substrates in which a buried oxide (BOX) is provided on a base, as the BOX can be used as an etch-stop.

In these devices, a thin highly doped p++ (or n++) first semiconductor layer is directly provided on the buried oxide and a second semiconductor layer with a lower dopant concentration (p-/n- layer) is then directly provided on the first semiconductor layer. The role of the highly doped layer is to passivate the interface between the semiconductor layer and the buried oxide to limit the dark current generated by interface defects. The second semiconductor layer corresponds to the region in which the photons are converted into electrons.

With the above-described substrates, an unsatisfying photon/electron conversion efficiency, in particular in short wave length region e.g. of blue light, was observed. Starting therefrom, it is therefore the object of the present invention to provide a method for fabricating the above-described kind of semiconductor substrate with an improved photon/electron conversion efficiency.

This object is achieved with the method of claim 1. Accordingly, the method comprises the steps of: a) providing a semiconductor on insulator type (SOI) substrate, in particular a silicon on insulator substrate, comprising a base, an insulating layer and a first semiconductor layer with a first dopant concentration, b) providing a diffusion barrier layer, and c) providing a second semiconductor layer, in particular of the same material as the first semiconductor layer, with the second dopant concentration different compared to the first dopant concentration, over, in particular on, the diffusion barrier layer.

By providing a diffusion barrier layer between the first semiconductor layer and the second semiconductor layer, the thickness of the transition region between the two dopant concentrations can be reduced. As a consequence, the photon/electron conversion efficiency can be improved.

Advantageously, the diffusion barrier layer and the first semiconductor layer have essentially the same lattice parameter. The semiconductor substrate will experience further processing steps to form the desired opto-electronic devices. During these further processing steps, the substrate will also undergo temperature gradients. By providing structures with similar or the same lattice parameters, the occurrence of unnecessary stress at the interface between the layers and which might lead to the generation of crystal defects, can be suppressed.

Advantageously, the diffusion barrier layer can be a Si_{1-x-y}GeₓC_{y} layer with 0 ≤ x ≤ 1 and 0 < y ≤ 0,04, preferably 0,03 ≤ y ≤ 0,04, in particular when the first and second dopants are one of boron and phosphorus. In particular, in the case of silicon as first and/or second semiconductor layer, the insertion of carbon into silicon or silicon germanium leads to a reduced diffusion coefficient in particular with respect to the dopants boron and phosphorus. Preferably, the species of the first and the second dopants are the same to facilitate the process.

Preferably, the composition of the diffusion barrier layer satisfies the condition x = αy, with 8 < α < 11. This indicates that one has to add α, in particular 9, atoms of germanium in case one adds one atom of carbon into the silicon crystalline structure. In this case, the lattice parameter of the first semiconductor layer and the diffusion barrier layer are matched (in the case of α=9) or at least nearly matched.

Preferably, the diffusion barrier layer can have a thickness of 0,5 µm or less, preferably less, in particular 10 to 500 nm, more in particular 20 to 50 nm. In particular, in combination with a lattice matched diffusion barrier layer with its reduced risk concerning strain occurring in the substrate during subsequent thermal process steps, the diffusion barrier layer can be grown to a thickness such that a desired dopant concentration profile, in particular with respect to the width of the transition region between highly and lowly doped regions, can be achieved.

Preferably, the first semiconductor layer can be a highly doped n++ or p++ semiconductor layer, thus with a dopant concentration in a range of **10¹⁷** atoms/cm³ up to 10²⁰ atoms/cm³ and the second dopant concentration of the second semiconductor layer can lead to a n- or p- semiconductor layer, thus with a dopant concentration in a range of 1 x 10¹³ to 5 x 10¹⁶ atoms/cm³. By providing the diffusion barrier layer in between those two semiconductor layers, it thus becomes possible to form substrates which can be used in the opto-electronic device fabrication and having transition regions with a thickness corresponding essentially to the one of the diffusion barrier layer, when the transition region is defined as the region where the dopant concentration starts from 90% of the maximum dopant concentration in the first semiconductor layer to 110% of the concentration in the second semiconductor layer.

Advantageously, the doping of the first and/or second semiconductor layer is obtained by in situ doping (ISD). In situ doping is a process characterized by flowing a dopant precursor over a heated substrate without deposition. In case of Si the temperature is typically up to 1000°C or more, in case of Ge rather up to 800°C or more. In situ doping is advantageous as compared to ion implantation as doping method in case that a further epitaxy step is needed.

Advantageously, the doping of the first and second semiconductor layers can be carried out in the same fabrication device, in particular in an epi-reactor. Using the epi-reactor, which is used to epitaxially grow the second semiconductor layer, furthermore facilitates the production line due to the fact that no additional step of implanting and an additional thermal treatment to activate the dopants is necessary. Furthermore it is also not necessary to provide an additional tool, such as a diffusion chamber for the doping.

According to a preferred embodiment, the base can be out of a transparent material. For instance, quartz type substrates can be employed to provide the transparency of the base substrate with respect to the visible wavelength range, which is necessary for opto-electronic applications.

Preferably, the diffusion barrier layer can be a multilayer layer structure comprising at least two layers. In this case, it becomes possible to further tailor the diffusion barrier layer to the needs of the final device. The various layers can be of different or the same material.

Advantageously, the first semiconductor layer can have a thickness in a range of 50 nm to 800 nm, preferably 55 nm to 200 nm and/or the second semiconductor layer can have a thickness in a range of up to 10 µm, and/or the insulating layer can have a thickness of 10 nm to 1500 nm, in particular 100 nm to 400 nm. With the advantageous method, it is possible to provide highly doped and lowly doped semiconductor layers within a wide range of thicknesses without having to worry about the smearing out of the dopant profile. In particular, it is possible to provide a thin highly doped layer in the presence of a thicker lowly doped layer by keeping the desired dopant profile.

Preferably, step a) can comprise the steps of: a1) providing a donor substrate, a2) providing a insulting layer on the donor substrate, a3) creating a predetermined splitting area inside the donor substrate, a4) bonding the donor substrate to the base substrate, detaching the remainder of the donor substrate from the bonded donor base substrate at the predetermined splitting area to thereby form the SOI substrate and doping of at least a part of the transferred semiconductor layer. With this so-called Smart Cut^{™} technology, high quality SOI wafers can be achieved and which can serve in the above described advantageous method.

Advantageously, the growth of the first layer, the growth of the diffusion barrier layer and the growth of the second semiconductor layer can be carried out in the same epi-reactor, which further optimizes the process. It is even further preferred to also carry out the in-situ doping in the same reactor.

The object of the invention is also achieved with the semiconductor substrate according to claim 14. The inventive semiconductor substrate comprises a base, an insulating layer, a first semiconductor layer, in particular a silicon layer, with a first dopant concentration, a diffusion barrier layer and a second semiconductor layer, in particular of the same material as the first semiconductor layer, with a second dopant concentration different compared to the first dopant concentration, over, in particular on, the diffusion barrier layer. By providing the diffusion barrier layer, the efficiency of the photon to electron conversion can be kept high as the smearing effect between different dopant concentrations can be reduced.

Advantageously, the diffusion barrier layer and the first semiconductor layer can have essentially the same lattice parameters. Thus, the occurrence of strain which might harm the substrate during subsequent fabrication steps can be reduced.

Preferably, the diffusion barrier layer can be a Si_{1-x-y}GeₓC_{y} layer with 0 ≤ x ≤ 1 and 0 < y ≤ 0,04, preferably 0,03 ≤ y ≤ 0,04. By introducing carbon into silicon or silicon germanium, the diffusion of boron or phosphorus can be greatly reduced.

Advantageously, the germanium and carbon content satisfy the following relation: x = αy, with 8 < α < 11. In this case, the lattice constant of the silicon germanium carbon layer is comparable to the one of the silicon semiconductor layer. Therefore, the thickness of diffusion barrier layer is not limited to the thickness of plastic relaxation thickness or crystal defect generation thickness commonly named critical layer thickness. Thus thicknesses in a range of up to several µm can be provided. It is although true that in cost point of view the thickness of the diffusion barrier has to be very close to its minimal thickness to prevent diffusion of B or P in order to have maximum epitaxy throughput and therefore minimum epitaxy cost.

The invention also relates to opto-electronic sensors, in particular an image sensor, comprising the semiconductor substrate fabricated as described above. As already mentioned, the inventive method allows to create a superior substrate which in turn will also improve the qualities of the final product, thus the image sensor which uses the substrate.

Advantageous embodiments of the invention will be described in the following in relation to the Figures.
Figures 1a - 1c illustrate the steps of one embodiment according to the inventive method for fabricating a semiconductor substrate, and
Figure 2 illustrates a typical dopant concentration profile in a semiconductor substrate according to the invention.

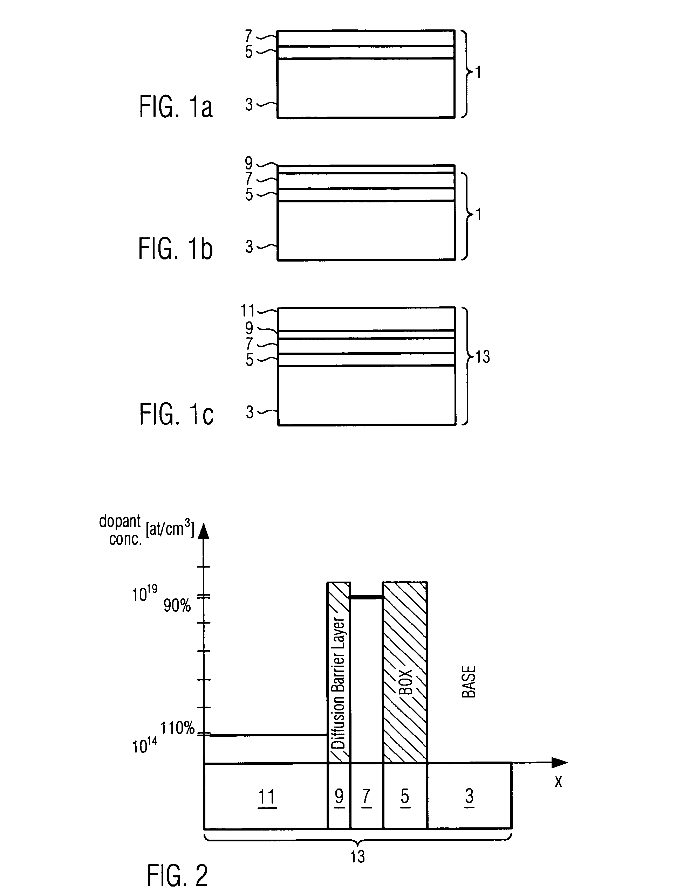

Figures 1a - 1c illustrate an embodiment for fabricating a semiconductor substrate according to the inventive method. According to step a) of claim 1 of the inventive method, a semiconductor on insulator type substrate 1 is provided. In this embodiment, the semiconductor on insulator type substrate is a silicon on insulator substrate.

One way to fabricate such a substrate 1 is the so called Smart Cut^{™} technology. This method typically comprises the steps of providing a donor substrate, e.g. a silicon wafer or a transparent substrate such as glass or quartz, providing an insulator layer on the donor substrate (e.g. using the natural oxide layer) and/or on a base substrate, like a silicon wafer, and creating a predetermined splitting area inside the donor substrate. The predetermined splitting area can be provided by implanting atomic species or ions such as helium or hydrogen into the donor substrate. In the next step, the donor substrate is bonded to the base substrate, such that the insulating layer is sandwiched between the base substrate and the donor substrate. Subsequently, the remainder of the donor substrate is detached from the bonded donor base substrate at the predetermined splitting area following a thermal and/or mechanical treatment upon the predetermined splitting area. As a result, a semiconductor on insulator (SOI) substrate, like illustrated in Figure 1a, is obtained. With this method, the insulating layer finds itself between the semiconductor layer, in the described example a silicon layer, transferred from the donor substrate and the base substrate. The insulating layer forms the so called buried oxide layer (BOX).

Thus, the SOI type substrate 1 illustrated in Figure 1 a comprises a base 3, typically silicon. However, depending on the application, also other materials are suitable, like for example transparent materials, such as glass or quartz, which find their application in opto-electronic devices.

An insulating layer 5, the abovementioned buried oxide layer, is provided on the base 3. The insulating layer 5 is typically a silicon oxide, but other insulating materials such as silicon nitride or a stack of layers might also form the insulating layer 5.
a first semiconductor layer 7 is provided over the insulating layer 5. As already mentioned above, in this embodiment, the semiconductor layer 7 is a silicon layer. However, other semiconductor materials such as germanium, might also be used.

For opto-electronic applications, the thickness of the insulating layer 5 is typically from about 10 nm to 1500 nm, preferably in a range of 100 nm to 400 nm. The semiconductor layer 7 typically has a thickness of 50nm to 800nm, preferably 55nm to 200nm.

The semiconductor layer 7 in this embodiment is a highly doped n++ or p++ layer with a dopant concentration in a range of 10¹⁷ atoms/cm³ up to 10²⁰ atoms/cm³. Preferably, doping is achieved via in situ doping (ISD) as described above.

The doping can, for example, be carried out in the diffusion chamber using boron or phosphorus atoms to obtain n-type or p-type kinds of doping in a flow of hydrogen with temperatures of about 900 - 1200°C, preferably 1050 - 1160°C for a time duration of 10 sec to 4 min.

Subsequently, a diffusion barrier layer 9 is provided on the first semiconductor layer 7 of the semiconductor on insulator substrate 1. In this embodiment, the diffusion barrier layer is a Si_{1-x-y}Geₓc_{y} layer with 0 ≤ x ≤ 1 and 0 < y ≤ 0,04, preferably 0,03 ≤ y ≤ 0,04. Preferably, the diffusion barrier layer is epitaxially grown onto the first semiconductor layer. By introducing carbon into a silicon or silicon germanium crystal, the diffusion coefficient of the dopant can be greatly reduced. This is in particular the case for boron and phosphorus. In addition, by growing the diffusion barrier layer 9 such that carbon and germanium satisfy the relation x = x = αy, with 8 < α < 11, the diffusion barrier layer 9 and the first semiconductor layer 7 have essentially the same lattice parameter.

The Si_{1-x-y}GeₓC_{y} layer can be obtained by a CVD process using organo-metallic precursors, like for example SiH₃CH₃ and/or GeH₃CH₃ and/or SiH₄ and/or GeH₄.

This is advantageous as, in subsequent fabrication process steps, the substrate might undergo thermal treatment steps in which case any difference in the lattice constants might lead to stress in the substrate.

In this embodiment, the diffusion barrier layer 9, having the same lattice parameter as the underlying first semiconductor layer 7, is grown to a thickness of 0,5 µm or less, in particular 10 to 500 nm, more in particular 20 to 50 nm. But also thicknesses of less than 0,1 µm are suitable to obtain the desired dopant profile.

In case that, according to a variant, another type of diffusion barrier layer 9 with a different material composition is provided, the advantageous effect of diffusion suppression can still be achieved, but to reduce the impact of different lattice constants, the thickness of the diffusion barrier layer shall not exceed the critical layer thickness for dislocation nucleation.

The diffusion barrier layer can be formed out of a plurality of different layers to form a multilayer structure.

In case of a Ge first semiconductor layer 7, the diffusion barrier layer can also be a Si_{1-x-y}GeₓC_{y} layer, in particular a stressed layer which can for example be provided by a layer transfer method, e.g. like a Smart Cut^{™} type process. Si_{1-x-y}GeₓC_{y} can be transferred with a Ge layer, that is typically highly doped before the transfer, because the top Si_{1-x-y}GeₓC_{y} transferred layer would otherwise prevent dopants to diffuse to the Ge layer during an hypothetical in situ doping step in this specific case.

Subsequently, as illustrated in Figure 1c, a second semiconductor layer 11 is provided on the diffusion barrier layer 9. In this embodiment, the second semiconductor layer 11 is expitaxially grown in an epi-reactor. For a silicon layer, the used precursor gases can be TCS, DCS or silane and for doping the layer in situ, again boron or phosphorus p-type or n-type dopants are used. The growth typically takes place at a temperature of 1000 - 1200°C and a layer with a thickness of up to 8 µm can be achieved. The dopant concentration is lower than in the first semiconductor layer 7 and is of the order of 1 x 10¹³ to 5 x 10¹⁶ atoms/cm³. Figure 1c also illustrates the final result which is the semiconductor substrate 13 according to the invention.

With the inventive method according to this embodiment and the inventive semiconductor substrate 13, a superior substrate is achieved as, due to the presence of the diffusion barrier layer 9 sandwiched between the first and second semiconductor layers 7 and 11, a diffusion of the dopants out of the highly doped first semiconductor layer 7 into the second semiconductor layer 11, can be suppressed. Thus, the second semiconductor layer 11 can play its role as a photon to electron conversion providing layer over its entire thickness which keeps the conversion efficiency optimized. Furthermore, the obtained dopant profile remains stable even during subsequent process steps under high temperature which are necessary to fabricate the opto-electronic devices on the second semiconductor layer 11.

Figure 2 illustrates a dopant concentration profile which can be achieved in the semiconductor substrate 11 illustrated in Figure 1 c. In the first semiconductor layer 7, the dopant concentration is ∼10¹⁹ atm/cm³ whereas in the second semiconductor layer the dopant concentration is ∼10¹⁴ atm/cm³. The transition region is actually defined as the thickness of the region between 90% of the concentration in layer 7 to 110% of the concentration in layer 11 which, in this case, may correspond to the thickness of the diffusion barrier layer 9 thus with a thickness of 0,5 µm or less.

The invention is not limited to the above-described embodiments as the method can be carried out according to other variants. It is, for example, possible that the doping of layers 7 and 11 can be carried out in the same chamber, namely the epi-reactor used to grow both the diffusion barrier layer 9 and the second semiconductor layer 11.

With the inventive method, the inventive substrate having an improved dopant concentration profile, also improves opto-electronic devices with a high photon to electron conversion efficiency and low dark currents can be achieved.

## Claims

1. Method for fabricating a semiconductor substrate comprising the steps of:
a) providing a semiconductor on insulator type (SOI) substrate, in particular a Silicon on insulator substrate, comprising a base, an insulating layer and a first semiconductor layer with a first dopant concentration,
b) providing a diffusion barrier layer, and
c) providing a second semiconductor layer, in particular of the same material as the first semiconductor layer, with a second dopant concentration different compared to the first dopant concentration, over, in particular on, the diffusion barrier layer.

2. Method according to claim 1, wherein the diffusion barrier layer and the first semiconductor layer have essentially the same lattice parameter.

3. Method according to claim 1 or 2, wherein the diffusion barrier layer is a Si_{1-x-y}GeₓC_{y} layer with 0 ≤ x ≤ 1 and 0 < y ≤ 0,04, preferably 0,03 ≤ y ≤ 0,04, in particular when the first and second dopants are one of boron or phosphorus.

4. Method according to claim 3, wherein x = αy, with 8 < α < 11, preferably x=9y.

5. Method according to one of claims 1 to 4, wherein the diffusion barrier layer has a thickness of 10 to 500 nm, in particular 20 to 50 nm.

6. Method according to one of claims 1 to 5, wherein after doping, the first semiconductor concentration leads to a highly doped n++ or p++ semiconductor layer and the second dopant concentration of the second semiconductor layer (13) leads to a n- or p-semiconductor layer.

7. Method according to one of claims 1 to 6, wherein the doping of the first and/or second semiconductor layer is obtained by in situ doping.

8. Method according to one of claims 1 to 7, wherein the doping of the first and second semiconductor layer is carried out in the same fabrication device (11), in particular an epi-reactor.

9. Method according to one of claims 1 to 8, wherein the base (3) is out of a transparent material.

10. Method according to one of claims 1 to 9, wherein the diffusion barrier layer is a multilayer structure comprising at least two layers.

11. Method according to one of claims 1 to 10, wherein the modified first semiconductor layer (7, 9) has a thickness in a range of 10 nm to 800 nm, preferably 55 nm to 200 nm, and/or the second semiconductor layer (13) has a thickness in a range of up to 10 µm, and/or the insulating layer (5) has a thickness of 10 nm to 1500nm, in particular 100 nm to 400 nm.

12. Method according to one of claims 1 to 11, wherein step a) comprises:
a1) providing a donor substrate,
a2) providing an insulating layer on the donor substrate or a base substrate,
a3) creating a predetermined splitting area inside the donor substrate,
a4) bonding the donor substrate to the base substrate,
a5) detaching a remainder of the donor substrate from the bonded donor-base substrate at the predetermined splitting area to thereby transfer a layer of the donor substrate including the insulating layer onto the base substrate to form the SOI substrate, and
a6) doping of at least a part of the transferred semiconductor layer.

13. Method according to one of claims 1 to 12, wherein the doping of the first semiconductor layer, the growth of the diffusion barrier layer and the growth of the second semiconductor layer are carried out in the same epi-reactor.

14. Semiconductor substrate comprising
a) a base (3),
b) an insulating layer (5),
c) a first semiconductor layer (7), in particular a Si layer, with a first dopant concentration,
d) a diffusion barrier layer (9), and
e) a second semiconductor layer (11), in particular of the same material as the first semiconductor layer, with a second dopant concentration different compared to the first dopant concentration, over, in particular on, the diffusion barrier layer (9).

15. Semiconductor substrate according to claim 13, wherein the diffusion barrier layer (9) and the first semiconductor layer (7) have essentially the same lattice parameter.

16. Semiconductor substrate according to claim 13 or 14, wherein the diffusion barrier layer is a Si_{1-x-y}GeₓC_{y} layer with 0 ≤ x ≤ 1 and 0 < y ≤ 0,04, preferably 0,03 ≤ y ≤ 0,.

17. Semiconductor substrate according to claim 15, wherein x = αy, with 8 < α < 11, preferably x = 9y.

18. Opto-electronic sensor, in particular image sensor, comprising the semiconductor substrate fabricated according to one of claims 1 to 12.
